# EUROPEAN PATENT SPECIFICATION

(11) **EP 0 402 811 B1**
(45) Date of publication and mention of the grant of the patent: **29.11.1995**
(21) Application number: 90110954.6
(22) Date of filing: 09.06.1990
(51) Int. Cl.: H05K 3/24, H05K 3/42, H05K 3/46, H05K 3/10

(54) **Method of manufacturing printed circuit boards**
Verfahren zur Herstellung gedruckter Schaltungsplatten
Méthode de production de panneaux à circuit imprimé

(30) Priority: 16.06.1989 EP 89110954
(43) Date of publication of application: 19.12.1990
(73) Proprietor: Hewlett-Packard GmbH, D-71004 Böblingen (DE)
(72) Inventor: Ott, Albert, D-7311 Bissingen (DE); Motz, Werner, D-7030 Böblingen (DE); Kornmayer, Werner, D-7039 Weil im Schönbuch (DE); Moser, Michael, Dr., D-7000 Stuttgart (DE)

(56) References cited:
- EP-A- 0 083 488
- EP-A- 0 090 900
- EP-A- 0 095 256
- DE-A- 2 048 942
- GB-A- 1 056 814
- US-A- 4 568 562
- ELECTRONIC ENGINEERING,vol. 58, no. 717, September 1986, London,GB;pages 21 - 22; "What is Riston dry film resist"
- RESEARCH DISCLOSURE,no. 269, September 1986,Emsworth, Hampshire,GB;NO. 26930: "Elimination of HCl rinse and substitution of water rinse"

## Description

The invention relates to a method of manufacturing printed circuit boards wherein metallic conductor structures according to a desired pattern are produced on a carrier board of isolating material. In particular, the invention relates to such a method wherein it is started from a carrier board having a metal foil, for example a copper foil, laminated to its surface.

Various methods for manufacturing printed circuit boards are known. An overview is given, for example, in the following publications: "Printed Circuits Handbook", C.F. Coombs, Jr. (ed.), McGraw-Hill 1988; "Handbuch der Leiterplattentechnik", Günther Herrmann, Eugen G. Leuze Verlag, 1982; EP-A2-0150733 .

The print & etch method is used particularly for producing one-sided printed circuit boards wherein the conductive paths are applied only on one side of the board, i.e., for printed circuits with low packing density. In the print & etch method it is started with a board of non-conductive material with a copper layer laminated to one or both sides of the board. The conductive structures of the printed circuit board may be applied by using, for example, screen-printing or photographic methods (applying photoresist, exposing, developing).

For manufacturing two-sided printed circuit boards or multilayer printed circuits, one of the following methods can be used: subtractive method, fully-additive method, or semi-additive method.

In the subtractive method, it is started from a copper-laminated isolating carrier plate, for example a glass-fibre reinforced epoxy resin plate with a copper foil on both sides of the plate having a typical thickness of 35 micrometers.

The inner layers of multilayer circuits are produced as follows: A positive resist is applied to the board, then the resist is exposed to light according to the pattern of conductive structures to be produced on the board and thereafter developed, then the uncovered copper is etched away, the resist is removed and the surface conductive paths is oxidized to form a protective layer. Finally, the thus produced inner layers are pressed together to a package such as to form a multilayer circuit.

For producing inner layers having through-holes, outer layers of multilayer circuits, and two-sided circuits according to the subtractive method, the following process steps are performed: first, the holes through which electrical contacts are to be established are drilled, then the walls of the through-holes are metallized by chemical deposition of copper, then the metallization of the walls of the through-holes is reinforced and the conductive paths are formed using the panel or pattern plating method; finally, the outer layers are covered with a solder stop.

The subtractive method has the disadvantage that the largest part of the comparatively thick copper foil has to be etched away for the production of the conductive paths thus causing considerable loss of copper. Furthermore, since under-etching of the conductive paths cannot be avoided, the subtractive method is limited to the production of conductive structures having dimensions , i.e., width and/or spacing of the conductive paths , of 80 to 100 micrometers.

The fully-additive method for manufacturing printed circuit boards differs from the subtractive method in that the starting board of isolating material is not covered with a copper foil, but that it is either a catalytic base laminate or covered with an adhesive. After drilling the through-holes and application of a resist, the sleeves of the through-holes and the conductive paths are formed by chemical deposition of copper.

In the semi-additive method, the starting material is the same as with the fully-additive method. After drilling the through-holes, however, the entire surface of the board is covered with a thin layer of chemically deposited copper. Thereafter, a negative resist is applied and the walls of the through-holes and the conductive structures are electroplated. After removing the resist, the thin copper layer between the conductive structures is etched away.

As compared to the fully additive method, the semi-additive method has the advantage that the metallic sleeves in the through-holes consist substantially of electroplated copper which has an increased ductility. Disadvantageous is the greater number of process steps. A disadvantage of the fully-additive and the semi-additive method in view of the subtractive method is that the adhesion of the conductor structures on the board of isolating material is worse in the additive methods. An advantage of the additive methods in view of the subtractive method is that the latter method permits in principle to produce finer conductor structures.

From GB-1056814 , a method for making printed circuit boards with conductive passageways through the insulating carrier board is known. In this known method, the walls of the through-holes are made conductive exclusively by electroless metal deposition. The method comprises a sensitizing step wherein at least the walls are treated with a sensitizing solution in order to ensure good adhering of the metal to the walls. During the electroless metal deposition on the walls of the through-holes, a layer of metal is also deposited on the conductive traces on the surface of the isolating carrier board to render such traces rugged.

Another method of manufacturing printed circuit boards is known from EP-A-0 090 900.

Relative to the prior art, it is an object of the invention to provide a method for manufacturing printed circuit boards which permits to produce fine conductor structures having width of and spacing between the conductor structures of 50 micrometers and below, and which at the same time provides good adhesion of the conductor structures on the isolating carrier board.

According to the invention, this object is solved by the features of claim 1 according to which it is started from an isolating carrier board having a metal foil laminated to its surface, and the final conductor structures are produced by chemical metal deposition on a pattern of conductive traces corresponding to the desired pattern of final conductor structures, said traces having as a base layer portions of the metal foil laminated to the carrier board. A deactivation step is performed after generation of the pattern of conductive traces and before the step of chemical metal deposition, for example by rinsing with hydrochloric acid. In this step, any substances on the isolating carrier board outside the conductive traces are removed in order to avoid that metal is deposited between said traces.

The invention is based on the finding that very fine conductor structures can be obtained when using a carrier board to which a metal foil is laminated which is substantially thinner than the foils used in the conventional subtractive method. According to the invention, the required final cross section of the conductor structures is produced by electroless chemical deposition of metal on a base layer comprising portions of said foil the pattern of which corresponds to the desired pattern of conductor structures. During that process step of chemical metal deposition, no catalyser (activator) or resist is present on the board such that metal is only deposited on the pattern of metal traces which were produced in the previous steps. The step of chemical metal deposition also ensures that any flaws in the pattern of conductor traces produced in the previous steps are compensated for. Such flaws may be due to pinholes in the thin metal foil laminated to the carrier board or to constrictions or scratches in the conductor traces caused during the process of their production. As a result of the chemical metal deposition, uniform flawless final conductor structures are obtained. Since the metal foil which forms the base layer of the conductor structures has been firmly laminated to the carrier board, it is ensured that the final conductor structures have good adhesion to the carrier board. The use of a thin metal foil permits precise etching of the desired pattern and thus enables the production of fine conductor structures with small dimensions. With the method of the invention, it is easily possible to achieve conductor structures having dimensions below 50 micrometers so that printed circuit boards with very high packing density can be produced.

According to the invention, the required conductor cross section can be produced by controlling the time during which chemical metal deposition occurs to form the final conductor structures or by appropriate selection of the composition of the chemical bath wherein the printed circuit board is immersed for chemical metal deposition. The required cross section may be determined by the required ohmic resistance of the final conductor structures or by impedance requirements or by requirements regarding heat dissipation of the current-carrying conductors.

The method of the invention can be used either for manufacturing one-sided printed circuit boards and inner layers of multilayer printed circuit boards without through-holes or for manufacturing the outer layers of multilayer printed circuit boards including metallization of the through-holes.

According to a preferred embodiment of the invention, the pattern of conductive traces is applied on the board by means of a photographic method wherein a layer of photoresist is applied on the metal foil, exposed according to the desired pattern and developed followed by an etching process. The use of thin resist layers also contributes to the attainment of fine conductor structures. In accordance with a further embodiment of the invention, the resist is a wet laminated dry film resist. Alternatively, it would also be possible to use a liquid resist.

In the production of printed circuit boards with through-holes it is advantageous to provide an intermediate step of electroplating the walls of the through-holes, because galvanically deposited metal ensures higher ductility. This is important because the through-holes may be subject to increased mechanical stress, particularly during soldering.

The metal deposited during the chemical metal deposition may be copper or nickel or nickel and gold. The use of nickel or nickel/gold has the advantage that, due to the good ductility of nickel, the thickness of the electroplated copper layer in the walls of the through-holes can be kept smaller than if the less ductile copper were used to form the final layer of the printed circuit board. Furthermore, a nickel/gold finish applied on solder pads has some advantages over a copper finish when electronic components are bonded to the printed circuit board.

In an embodiment of the invention, a soldermask is applied to the printed circuit board after the step of chemical metal deposition, and this soldermask is exposed and developed to generate a pattern of a solder stop layer such that only the portions on the surface of the board remain free of the solder stop layer where electronic components are to be soldered to or bonded to, as well as the through-holes. Then, chemical metal deposition on the free portions is performed, i.e., on top of the layer of chemically deposited metal, whereby the preferred metals used for this final metal deposition are nickel, or nickel and gold.

The invention has the further advantages that no special materials for the isolating carrier board are required and that known per se materials and substances in the various process steps can be used. Furthermore, no solvents comprising chlorinated hydrocarbons are required , so that the entire method is ecologically beneficial. According to another advantage, desired cross sections of the final conductors can be achieved in an easy way by correspondingly controlling the duration of the chemical metal deposition. This is particularly important when there are stringent requirements regarding the impedance of the conductor structures of the printed circuit.

Subsequently, embodiments of the invention are described in detail with reference to the drawings:
- Figures 1a-f: schematically depict cross sections through an inner layer of a multilayer printed circuit board at different process steps during the production process according to the invention,
- Figures 2a-l: schematically depict cross sections through a multilayer printed circuit board at different process steps during the production of outer layers having through-holes according to the invention.

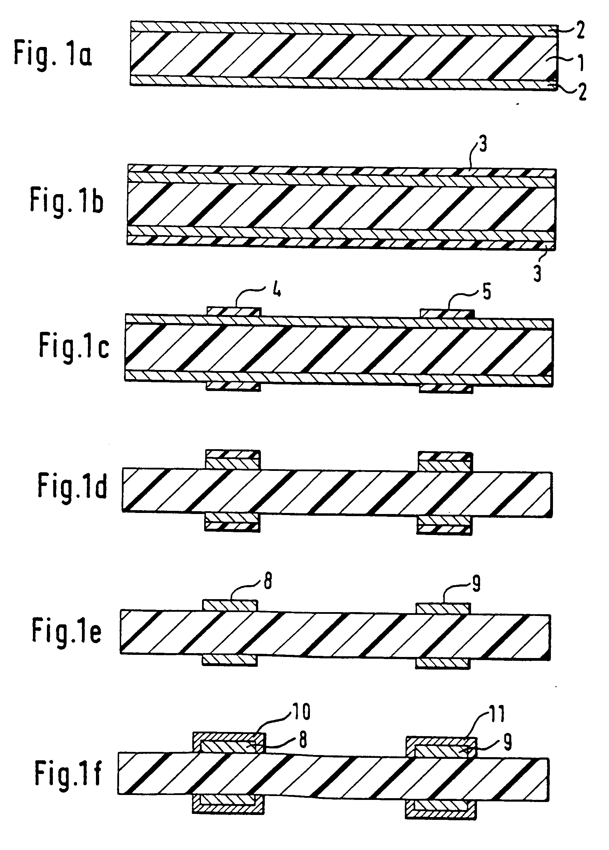

In Figure 1 is illustrated the method of the invention for manufacturing inner layers of a multilayer printed circuit board which has no through-holes.

According to Figure 1a, it is started from a carrier plate 1 of an isolating material such as glass-fibre reinforced epoxy resin, polyimide or cyanate esther. This plate 1 is coated on both sides with a thin copper foil 2 which is intimately connected to the carrier plate 1. It is possible, for example, to start from boards of isolating material to which a thin layer of a copper foil has been laminated with good adhesion. The thickness of the copper foil 2 is selected according to the desired dimensions of the conductor structures which are to be applied to the board. According to some practical examples, the thickness of foil 2 may be 17,5 or 10 or 5 micrometers.

In the next step as shown in Figure 1b, a layer of photoresist 3 is applied on both sides of the board onto the copper foil 2. Any known type of photoresist can be used. In an embodiment of the invention, an aqueous alkaline dry film photoresist layer is wet laminated onto the copper layer 2 on both sides of the board.

Then, the resist 3 is exposed with a negative mask in accordance with the pattern of conductor structures to be applied to the board and thereafter, a positive image is developed according to methods known per se in the manufacture of printed circuit boards. The result is shown in Figure 1c, wherein reference numerals 4 and 5 denote parts of the pattern of photoresist which corresponds to the desired pattern of conductive paths. The portion of the copper foil 2 which is not covered by resist 4,5 is then etched away , so that the structure shown in Figure 1d results, i.e. a pattern of copper traces covered with resist. The etching solution can be, for example, a hydrochloric solution of copper chloride.

After the etching, it is preferred that the board 1 is deactivated by rinsing with an appropriate liquid such that the locations on the surface of the board 1 which are not covered with resist 5 are completely clean and do not contain any contaminations like metallic foreign substances. The reason for this deactivation step is that any residues on the board from previous steps could act as unwanted nuclei for metal growth in the subsequent step of electroless metal deposition (explained in connection with Figure 1f). A preferred cleaning liquid is concentrated hydrochloric acid.

It was found that by rinsing with hydrochloric acid, the copper (I) chloride which is obtained in the etching step (Figure 1d) is resolved as chloro complex and can thus be removed from the board. The rinsing with hydrochloric acid further removes any residues due to polluted chemicals, for example ferric chloride. Furthermore, metal abrasion (iron, nickel) and dust (calcium sulphate) are removed by this rinsing step. As a result of the deactivation step, the surface of the isolating carrier board 1 between the pattern of conductor structures 8,9 with the resist layer 4,5 on top is completely free of foreign substances. Thus, in the step of chemical metal deposition to be described below in connection with Figure 1f, metal will only be deposited on the conductor traces and not between them.

In the next step, the result of which is shown in Figure 1e, the resist is removed by any suitable method used in the production of printed circuit boards. The isolating carrier board 1 is then covered with a pattern of conductive traces 8, 9 having the thickness of the copper foil 2 originally laminated to the board 1.

Finally, copper is chemically deposited on top of the conductive paths 8,9 to form the desired final cross section of the conductors on the board. The result is shown in Figure 1f depicting chemically deposited layers 10,11 on top of the copper layers 8,9. For this process step, known so-called additive baths for chemical copper deposition can be used. Since the board has not been provided with a catalyst or activator, and since the spaces between the conductors have been rinsed with hydrochloric acid so that the isolating carrier board is free of foreign substances which might act as nuclei for metal deposition, copper is only deposited on the portions 8, 9 of the original copper foil 2 which have not been etched away in the earlier etching step, whereas the the remaining parts of the carrier plate 1 stay free of copper. According to the invention, it has been found that uniform conductive paths with small dimensions can be produced by that method. In the preceding, the production of conductors on only one side of the board has been described , but it is understood and it can be seen from Figure 1 that by that method patterns of conductors can be produced on both sides of the board.

Problems with copper residues which might remain after the etching step at areas of the carrier board outside the desired conductive traces 8,9 can be reduced by using laminated copper foils 2 which have a comparatively fine treatment, that means that the surface of the foil which is in contact with the board is not roughened too strongly so that the portions of the foil located between the desired conductor structures can be better etched away.

It is understood that the method described in connection with Figures 1a - f can be used for the production of either single-layer printed circuit boards having conductor structures on one or both sides of the board or for the production of inner layers of multilayer printed circuit boards without through-holes.

In an alternative embodiment of the invention for producing inner layers, an additional process step between the steps illustrated in Figures 1a and 1b is applied: It is started with a very thin copper foil 2 laminated to both sides of the carrier board 1, for example with a thickness of about 5 micrometers. Then, according to this embodiment, a layer of copper, having a thickness of, for example, 3 to 5 micrometers is electrolessly deposited on the copper foil 2. In the next step, photoresist is applied on the copper as shown in Figure 1b. This step and the following steps are the same as the steps explained above in connection with Figures 1b to 1f. The alternative embodiment just described can be used if the initial copper foil 2 laminated to the isolating carrier board is very thin so that it may comprise pinholes. The step of electroless copper deposition on the entire copper foil has the purpose to produce a uniform copper layer free of any defects.

It is understood that various modifications of the two described embodiments of the process of the invention for the production of inner layers are possible. What is essential is that the final conductor structures are produced by chemical metal deposition on the previously produced pattern of conductive traces, whereby the process starts with a carrier board to which a thin metal foil has been laminated. Regarding the process steps and materials for producing the desired pattern of conductive traces, a plurality of alternatives are possible.

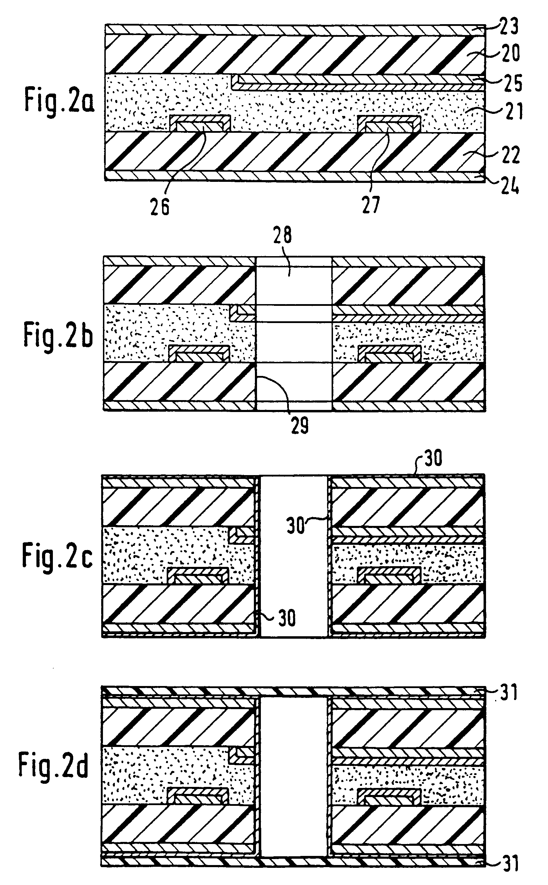

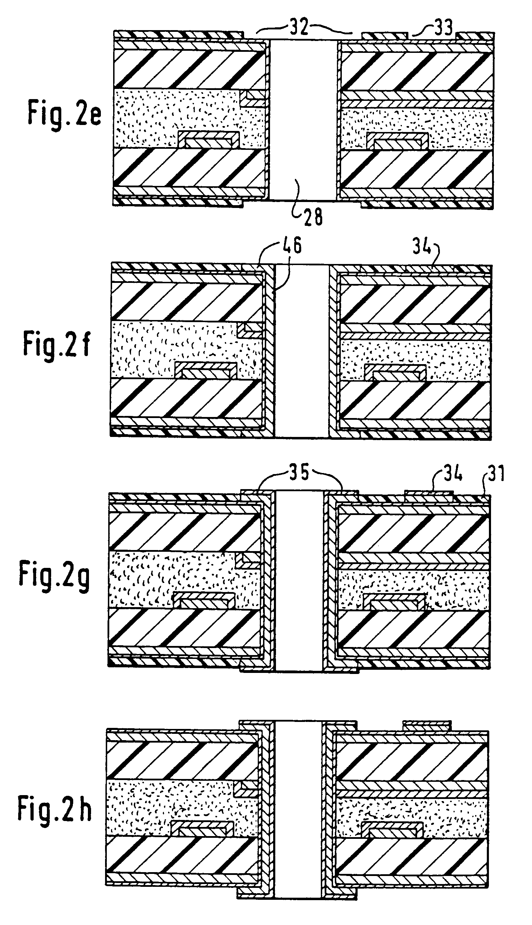

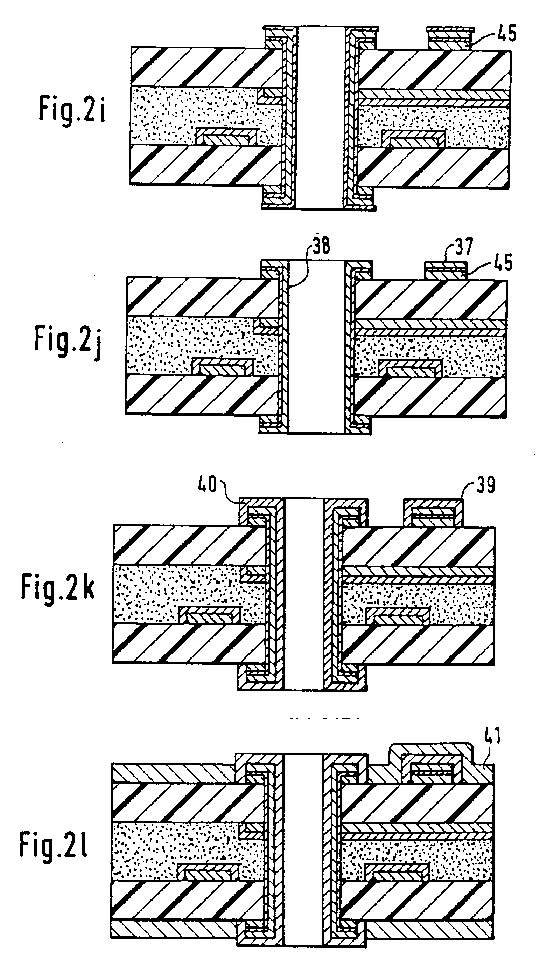

In the following, the process according to the invention for producing inner layers of multilayer printed circuit boards having through-holes and outer layers is explained with reference to Figure 2. In Figure 2a is shown a multilayer package of printed circuit boards comprising a first board 20 of isolating material on which conductive structures 25 have been applied, preferably with a process as described in connection with Figure 1. A copper foil 23 , similar to the foil 2 of Figure 1 is laminated onto the other side of the board 20. A second board 22 is equipped on one side with conductive structures 26,27 and on the other side with a copper foil 24. Sandwiched between the boards 20 and 22 is an adhesive layer 21 ; the entire arrangement is pressed together to form a package.

In the first step, illustrated in Figure 2b, through-holes 28 are drilled according to a desired pattern. The walls 29 of the through-holes are then activated, for example by nucleation with palladium,to permit chemical copper deposition. In the following process step, a comparatively thin copper layer 30 is chemically deposited on the entire surface of the board including the walls 29 of the through-holes (dotted layer in Figure 2c).

According to Figure 2d, a photoresist layer 31 is applied on both sides of the board on top of the layer 30. The photoresist layer 31 can be the same as the photoresist layer 3 of Figure 1b. The resist is then exposed by means of a positive mask according to the desired pattern of conductor structures and a negative image is developed, i.e., those portions 33 of the board where the final conductors are to appear and the edges 32 of the through-holes 28 are not covered with resist (Figure 1e).

In the step according to Figure 2f, electroplating of the walls of the through-holes and of the free spaces 32, 33 in the resist layer 31 takes place. The conductive paths 34 formed in that way and the metallized walls and edges 46 of the through-holes are then electroplated with a layer of metal resist 35, 36, for example a layer of tin (Figure 2g). Thereafter, the photoresist 31 is removed (Figure 2h) in a known per se way.

According to Figure 2i, the uncovered copper is etched away, using, for example, an ammonia alkaline etching solution, and the metal resist is then removed (Figure 2j). As a result thereof, the board is now covered with a pattern of conducting traces, with portions 45 of the original copper foil 23 forming the base layer. Then, rinsing with concentrated hydrochloric acid is performed as explained in connection with Figure 1d in order to remove any residues from the isolating carrier board between the conductive traces.

Now, in accordance with an important step of the method of the invention, the conductive paths 37 and the conductive walls 38 of the through-holes are subject to chemical copper deposition, i.e.,a copper layer 39, 40 is chemically deposited on the traces 37, 38 to produce the final cross section of the conductors (Figure 2k). Finally, a solder stop layer 41 is applied to cover those portions of the surface of the board where no metal has been deposited. It is understood that production of conductor structures on the lower side of the multilayer board occurs in the same way and simultaneously with the just described production of conductor structures on the upper side.

According to a practical example of the invention, conductor structures can be created having dimensions of 50 micrometers or less when using a copper foil 2, 23 with a thickness of 17,5 micrometers and a resist film 3, 31 having a thickness of 15 micrometers. When the chemical copper deposition (Figure 1f, Figure 2k) is performed for about 3 1/2 hours, the thickness of the chemically deposited layer is about 12 micrometers resulting in a total thickness of the conductor structures of about 30 micrometers. It is understood, that various chemical baths can be used for the step of chemical copper deposition so that the time required to deposit a layer of a certain thickness can vary depending on the chemical bath employed. A thickness of the conductor structures of about 30 micrometers is presently customary for printed circuit boards, but it is understood that the invention permits to produce conductor structures of any desired thickness.

In an example of the invention, the layer 30 of chemically deposited copper (Figure 2c) may have a thickness of about 2 micrometers; the copper layer 34 applied during the step of electroplating (Figure 2f) may have a thickness of about 15 micrometers and the tin layer 35,36 (Figure 2g) of about 5 micrometers.

Preferred copper baths wherein the circuit board is immersed during chemical copper deposition are "additive baths" which typically comprise the following components: a cupric salt, a complexing agent, a reducing agent, a base, and a stabilizing agent. Such additive baths as such are known in the art, for example under the name "Ultraganth" available from the company Schering AG, Berlin. The additive baths can still be optimized by corresponding selection of the above-mentioned components such that it is ensured that the final conductor structures have good hardness, good adhesion to the copper base layer, high conductivity, and small porosity. Generally speaking, the copper baths used should ensure that the deposited copper has a structure which is similar to the crystalline structure of electroplated copper. In an embodiment of the invention, this may be achieved by selecting the concentration of the cupric salt in the additive bath smaller than about 0.05 mol per liter.

According to a further embodiment of the invention, the step of chemical metal deposition may comprise chemical deposition of nickel (instead of copper) whereby known per se chemical nickel baths can be used. The use of nickel has the advantage that it has a greater ductility than copper, leading to increased mechanical strength of the hole walls. Due to this increased strength, the layer of electroplated copper applied on the walls in a previous step, can be kept smaller than in case that copper is used for chemical metal deposition. In a practical example, a 10 micrometer thick nickel layer is chemically deposited on the copper structures whereby the surface of the copper structures has been activated to ensure good adhesion of the nickel on the copper. Finally, a thin layer of gold, typically 0,1 to 0,15 micrometers thick, can be applied on the nickel layer by electroless deposition. The gold layer prevents nickel passivity and thus ensures good solderability.

A nickel/gold finish on solder pads has the further advantages that it is a very suitable finish for bonding electronic components (instead of soldering) to the board. Furthermore, nickel provides a diffusion barrier for any bondmetals. A nickel/gold finish is also advantageous when demountable pads are used. Since nickel has comparatively small corrodibility, the use of a nickel or nickel/gold layer as the outer layer enclosing the copper traces beneath, contributes to a high reliability of the printed circuit board.

The process described in connection with Figures 2a to 1 for producing outer layers of multilayer printed circuit boards or for producing inner layers with through-holes is of course not the only one possible. Here, again as with the above-described inner layer process, it is essential that the final conductor structures and the final metal coating of the through-holes are produced by a step of electroless deposition on a pattern produced in previous process steps, starting with a thin metal foil laminated to the outer boards.

According to an alternative embodiment, the metal foils on the top and bottom layers of the multilayer package may have a greater thickness than those in the embodiment described in connection with Figure 2. The reason that one starts with a thicker metal foil is, for example, that isolating carrier boards with very thin foils are more expensive to manufacture. In such an embodiment, the thickness of the metal foil is first reduced by etching to a thickness which permits to achieve the desired fine conductor structures. Then, as in the embodiment of Figure 2, through-holes are drilled. As an alternative to the step of chemical copper deposition shown in Figure 2c, several successive process steps can be employed which essentially consist in the electroless deposition of a thin metal layer on the entire surface of the board and on the walls of the through-holes followed by electroplating of the metal surfaces. Then, corresponding to Figure 2d of the above-described embodiment, a photoresist layer is applied on both sides of the board, and the resist is exposed and developed corresponding to the desired pattern of conductive traces.

For the production of the conductive traces, either a positive or a negative photomask may be used, i.e., the pattern of developed photoresist may correspond either to the free spaces between the conductive traces or to the pattern of conductive traces itself. In the following steps, the spaces between the developed photoresist and the walls of the through-holes may be electroplated with a metal resist. Subsequently, the photoresist is removed, then the uncovered copper is etched away and then the metal resist is removed before the final conductor paths are produced by chemical metal deposition. Before the step of electroless metal deposition, it is preferred that rinsing with hydrochloric acid is performed to remove any unwanted material from the surface of the isolating carrier board.

Then, a soldermask is laminated to the surface of the board, exposed and developed according to a predetermined pattern. As a result of this, the conductive paths and the spaces between them are covered with a solder stop layer, and only the locations where electrical components are to be soldered or bonded to the board as well as the through-holes and the neighbourhood of the through-holes on the surface of the board are free of the solder stop layer. In the next step, a layer of nickel is electrolessly deposited on the free spaces on the board (i.e., the spaces not covered with solder stop), and thereafter a layer of gold is electrolessly deposited on the nickel layer. The nickel layer contributes to hardness and corrosion protection and the gold layer ensures good surface conductivity. In a practical example of this embodiment, the nickel layer has a thickness of 6 to 8 micrometers, and the final gold layer has a thickness of 0.1 micrometers.

According to a still further embodiment of the invention, when a negative mask has been used for the exposure of the photoresist, the uncovered copper is etched away after development of the resist, then the photoresist is removed before the final conductor paths are produced by chemical metal deposition.

In all embodiments, it is to be ensured that before the step of electroless metal deposition on the conductive traces, the surface of the board where no conductors are to appear has been deactivated, preferably by rinsing with hydrochloric acid.

In all embodiments, a soldermask may finally be applied to the top and bottom surface of the printed circuit board or the multilayer package to cover the conductive traces and the portions of the board surface where no metal has been deposited. Alternatively, a soldermask may be laminated to the board, then exposed and developed prior to the step of chemical metal deposition. The solder pattern is selected such that the conductive traces and the portions of the board where there is no metal are covered with solder stop, whereas solder pads and through-holes are not covered. Then, in the final step of electroless deposition, only the solder pads and the through-holes are covered with an additional metal layer of, for example, copper or nickel or nickel and gold.

## Claims

1. A method of manufacturing printed circuit boards, for producing metallic conductor structures according to a desired pattern on a carrier board of isolating material, and for producing metallized through holes in the carrier board, wherein:
a) a metal foil (23) is laminated to the surface of the carrier board (20),
b) through-holes (28) are drilled through the carrier and the metal foil,
c) a pattern of conductive traces (37) is formed from the metal foil corresponding to the desired pattern,
d) a metal layer (46) is electroplated on the walls of the through holes,
e) the locations outside the desired pattern are deactivated by removing any substances on the carrier board to avoid metal deposition at such locations,
f) a metal layer (39,40) is chemically deposited on the walls of the through-holes and the conductive traces (37), to produce the final conductor structures, said traces having as base layer portions (45) of the metal foil laminated to the board.

2. A method as in claim 1, wherein the deactivation step comprises rinsing of the carrier board (20) with hydrochloric acid.

3. A method as in claim 1 or 2, wherein the pattern of conductive traces (37) is produced by means of the steps of applying a photoresist layer (31), exposing the photoresist layer to radiation according to the desired pattern of conductor structures, and developing the photoresist layer.

4. A method as in any of the preceding claims, wherein the thickness of the metal foil (23) is less than approximately 17 micrometers.

5. A method as in claim 3 or 4, wherein the resist (31) is a dry film resist.

6. A method as in claim 5, wherein the thickness of the resist layer (31) is less than approximately 15 micrometers.

7. A method as in any of the preceding claims, wherein the metal (39) chemically deposited on the conductive traces (37) is copper.

8. A method as in claim 7, wherein the printed circuit board is immersed in an additive bath during the step of chemical metal deposition, said bath comprising a cupric salt in a concentration of less than about 0.05 mol/liter.

9. A method as in any of the claims 1 to 6, wherein the metal (39) chemically deposited on the conductive traces (37) is nickel or nickel and gold.

10. A method as in any of the preceding claims, comprising the following steps after the step of chemical metal deposition on the pattern of conductive traces:
i) applying a protective layer (solder mask) to the surface of the board,
ii) exposing and developing said solder mask according to a predetermined pattern, and
iii) electroless deposition of a metal on those portions (e.g., contact pads, through-holes) of the surface of the board which are not covered with the developed protective layer.

11. A method as in claim 10, wherein the metal which is electrolessly deposited in step iii) is nickel, and wherein after the deposition of nickel a layer of gold is electrolessly deposited on the nickel layer.

## Patentansprüche

1. Verfahren zur Herstellung gedrucker Schaltungsplatten, um metallische Leiterstrukturen gemäß einem gewünschten Muster auf einer Trägerplatte aus isolierendem Material zu erzeugen, und um metallisierte Durchgangslöcher in der Trägerplatte zu erzeugen, bei dem
a) eine Metallfolie (23) an die Oberfläche der Trägerplatte (20) laminiert wird,
b) Durchgangslöcher (28) in den Träger und die Metallfolie gebohrt werden,
c) ein Muster leitfähiger Bahnen (37) aus der Metallfolie gemäß dem gewünschten Muster gebildet wird,
d) eine Metallschicht (46) galvanisch auf die Wandungen der Durchgangslöcher aufgebracht wird,
e) die Stellen außerhalb des Musters durch Entfernen etwaiger Substanzen auf der Trägerplatte inaktiviert werden, um Metallabscheidung an diesen Stellen zu verhindern,
f) eine Metallschicht (39,40) auf die Wandungen der Durchgangslöcher und die leitfähigen Bahnen (37) zur Bildung der endgültigen Leiterstrukturen chemisch abgeschieden wird, wobei die Bahnen als Grundschicht Teile (45) der auf der Platte laminierten Metallfolie haben.

2. Verfahren gemäß Anspruch 1, bei dem der Inaktivierungsschritt das Spülen der Trägerplatte (20) mit Salzsäure umfaßt.

3. Verfahren gemäß Anspruch 1 oder 2, bei dem das Muster leitfähiger Bahnen (37) durch die Schritte Auftragen einer Fotoresistschicht (31), Aussetzen der Fotoresistschicht einer Bestrahlung gemäß dem gewünschten Muster der Leiterbahnen und Entwicklung der Fotoresistschicht hergestellt wird.

4. Verfahren gemäß einem der vorhergehenden Ansprüche, bei dem die Dicke der Metallfolie (23) weniger als etwa 17 Mikrometer beträgt.

5. Verfahren gemäß Anspruch 3 oder 4, bei dem das Resist (31) ein Trockenfilmresist ist.

6. Verfahren gemäß Anspruch 5, bei dem die Dicke der Resistschicht (31) weniger als etwa 15 Mikrometer beträgt.

7. Verfahren gemäß einem der vorhergehenden Ansprüche, bei dem das auf die leitfähigen Bahnen (37) chemisch abgeschiedene Metall (39) Kupfer ist.

8. Verfahren gemäß Anspruch 7, bei dem die gedruckte Schaltungsplatte während des Schrittes der chemischen Metallabscheidung in einem Additivbad eingetaucht ist, wobei das Bad ein Kupfer(II)-salz in einer Konzentration unter etwa 0.05 mol/l enthält.

9. Verfahren gemäß einem der Ansprüche 1 bis 6, bei dem das auf die leitfähigen Bahnen (37) chemisch abgeschiedene Metall (39) Nickel bzw. Nickel und Gold ist.

10. Verfahren gemäß einem der vorhergehenden Ansprüche, das nach dem Schritt der chemischen Metallabscheidung auf das Muster leitfähiger Bahnen folgende Schritte umfaßt:
i) Auftragen einer Schutzschicht (Lötstoppmaske) auf die Plattenoberfläche,
ii) Belichtung und Entwicklung der Lötstoppmaske gemäß einem vorgegebenen Muster,
iii) stromlose Abscheidung eines Metalls auf die Stellen (z. B. Lötanschlußflächen, Durchgangslöcher) der Plattenoberfläche, die nicht durch die entwickelte Schutzschicht abgedeckt sind.

11. Verfahren gemäß Anspruch 10, bei dem das im Schritt iii) abgeschiedene Metall Nickel ist und nach der Abscheidung von Nickel eine Goldschicht auf die Nickelschicht stromlos abgeschieden wird.

## Revendications

1. Procédé de production de cartes de circuit imprimé, pour produire des structures de conducteurs métalliques conformément à un motif souhaité sur une carte formant support en matériau isolant, et pour produire des trous traversants métallisés dans la carte formant support, dans lequel:
a) une feuille métallique (23) est stratifiée à la surface de la plaque formant support (20).
b) des trous traversants (28) sont percés à travers le support et la feuille métallique,
c) un motif de pistes conductrices (37) est formé à partir de la feuille métallique en correspondance au motif souhaité,
d) une couche metallique (46) est déposée électrolyse sur les parois des trous traversants,
e) les endroits se trouvant en dehors du motif souhaité sont désactivés en enlevant toutes les substances sur la carte formant support afin d'éviter un dépôt de métal en ces endroits,
f) une couche métallique (39, 40) est déposée de manière chimique sur les parois des trous traversants et les pistes conductrices (37), pour produire des structures de conducteurs finales, lesdites pistes ayant comme couche de base des parties (45) de la feuille métallique stratifiée sur la carte.

2. Procédé selon la revendication 1, dans lequel l'étape de désactivation comprend un rinçage de la carte formant support (20) avec de l'acide chlorhydrique.

3. Procédé selon la revendication 1 ou 2, dans lequel le motif de pistes conductrices (37) est un produit au moyen d'étapes consistant à appliquer une couche de photoréserve (31), à exposer la couche de photoréserve à un rayonnement conformément au motif souhaité des structures de conducteurs, et à développer la couche de photoréserve.

4. Procédé selon l'une quelconque des revendications précédentes, dans lequel l'épaisseur de la feuille métallique (23) est inférieure à approximativement 17 microns.

5. Procédé selon la revendication 3 ou 4, dans lequel la réserve (31) est une réserve sèche.

6. Procédé selon la revendication 5, dans lequel l'épaisseur de la couche de réserve (31) est inférieure à approximativement 15 microns.

7. Procédé selon l'une quelconque des revendications précédentes, dans lequel le métal (39) déposé de manière chimique sur les pistes conductrices (37) est du cuivre.

8. Procédé selon la revendication 7, dans lequel la carte de circuit imprimé est immergée dans un bain d'additif pendant l'étape de dépôt chimique de métal, ledit bain comprenant un sel de cuivre avec une concentration inférieure à environ 0,05 mole/litre.

9. Procédé selon l'une quelconque des revendications 1 à 6, dans lequel le métal (39) déposé de manière chimique sur les pistes conductrices (37) est du nickel ou du nickel et de l'or.

10. Procédé selon l'une quelconque des revendications précédentes, comprenant les étapes suivantes faisant suite à l'étape de dépôt chimique de métal sur le motif de pistes conductrices :
i) l'application d'une couche protectrice (masque de soudure) à la surface de la carte,
ii) l'exposition et le développement dudit masque de soudure conformément à un motif prédéterminé, et
iii) le dépôt non électrolytique d'un métal sur ces parties (par exemple, des plots de contact, des trous traversants) de la surface de la carte qui ne sont pas recouvertes avec la couche protectrice développée.

11. Procédé selon la revendication 10, dans lequel le métal déposé de manière non électrolytique à l'étape iii) est du nickel, et dans lequel, après le dépôt de nickel, une couche d'or est déposée de manière non électrolytique sur la couche de nickel.
